# EUROPEAN PATENT APPLICATION

(11) **EP 4 425 567 A1**
(43) Date of publication of application: **04.09.2024**
(21) Application number: 24158005.9
(22) Date of filing: 16.02.2024
(51) Int. Cl.: H01L 29/40, H01L 29/66, H01L 29/78, H01L 29/739

(54) **SPLIT-GATE TRENCH POWER MOSFET WITH THICK POLY-TO-POLY ISOLATION**

(30) Priority: 01.03.2023 US 202363449092 P; 31.01.2024 US 202418428306
(71) Applicant: STMicroelectronics International N.V., 1228 Plan-les-Ouates, Geneva (CH)
(72) Inventor: NGWAN, Voon Cheng, 732686 Singapore (SG); YIM, Churn Weng, 822211 Singapore (SG); ENEA, Vincenzo, 96100 Siracusa (IT)
(74) Representative: Cabinet Beaumont

(57) **Abstract**

A semiconductor substrate has a substrate trench extending from a front surface and including a lower part and an upper part. A first insulation layer lines the substrate trench, and a first conductive material is insulated from the semiconductor substrate by the first insulating layer to form a transistor field plate electrode. A gate trench in the first insulation layer defines an integral part of the first insulating layer surrounding the first conductive material in an upper part of the substrate trench. A second insulating layer lines the semiconductor substrate at the upper part of the substrate trench in the gate trench. A second conductive material fills the gate. The second conductive material forms a transistor gate electrode that is insulated from the semiconductor substrate by the second insulating layer and further insulated from the first conductive material by the integral part of the first insulating layer.

## Description

### CROSS REFERENCE TO RELATED APPLICATIONS

This application claims priority from United States Provisional Application for Patent No. 63/449,092, filed March 1, 2023, and from United States Application for Patent No. 18/428,306, filed January 31, 2024, the disclosure of which is incorporated herein by reference.

### TECHNICAL FIELD

The present invention generally relates to metal oxide semiconductor field effect transistor (MOSFET) devices and, in particular, to a split-gate trench power MOSFET device.

### BACKGROUND

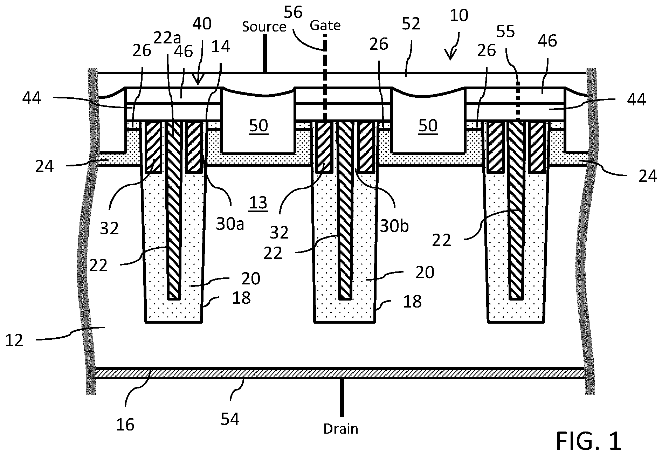

Reference is made to Figure 1 which shows an embodiment of a cross-section of a split-gate trench power metal oxide semiconductor field effect transistor (MOSFET) device 10. In this example, the MOSFET device 10 is an n-channel (nMOS) type transistor formed in and on a semiconductor substrate 12 (for example, silicon) doped with n-type dopant providing the drain region of the transistor 10. The substrate 12 has a front side 14 and a back side 16. A plurality of trenches 18 extend depthwise into the substrate 12 from the front side 14. The trenches 18 extend lengthwise parallel to each other in a direction perpendicular to the cross-section (i.e., into and out the page of the illustration), with adjacent trenches delimiting side edges of a mesa region 13 of the transistor forming a strip (this type of transistor device commonly referred to in the art as a strip-FET type transistor).

A region 24 doped with a p-type dopant is buried in the mesa region 13 of the substrate 12 at a depth offset from (i.e., below) the front side 14 and positioned extending parallel to the front side 14 on opposite sides of each trench 18. The doped region 24 forms the body (channel) region of the transistor, with the trench 18 passing completely through the doped body region 24 and into the substrate 12 below the doped body region 24. A surface region 26 heavily doped with an n-type dopant is provided in the mesa region 13 at the front side 14 of the substrate 12 and positioned extending parallel to the front side 14 on opposite sides of each trench 18 and in contact with the top of the doped body region 24. The doped region 26 forms the source region of the transistor, with the trench 18 passing completely through the doped source region 26 and further extending, as noted above, completely through the doped body region 24 into the substrate 12 below the doped body region 24.

The side walls and bottom of each trench 18 are lined with a first insulating layer 20. Each trench 18 is filled by a first polysilicon material 22, with the first insulating layer 20 insulating the first polysilicon material 22 from the substrate 12. The first polysilicon material 22 in the trench 18 forms a field plate electrode of the transistor 10. An upper portion of the first insulating layer 20 (which would be adjacent to both the doped body region 24 and doped region 26, for example) is removed from an upper part of the trench 18 to form an annular trench surrounding a corresponding upper portion 22a of the first polysilicon material 22. The side walls (inner and outer) of the annular trench are then lined with a second insulating layer 30a and third insulating layer 30b. For example, the second and third insulating layers 30a, 30b may each comprise an oxide layer (which, in an embodiment, is thermally grown from the exposed surfaces of the substrate 12 in each annular trench and the exposed surfaces of the upper portion 22a of the first polysilicon material 22). The remaining open portion of each annular trench is then filled by a second polysilicon material 32. The second polysilicon material 32 in the upper part of the trench 18 forms the gate of the transistor 10. The second insulating layer 30a insulates the second polysilicon material (gate) 32 from the substrate 12 and forms the gate oxide layer for the transistor. The third insulating layer 30b insulates the second polysilicon material (gate) 32 from the upper portion 22a of the first polysilicon material (field plate) 22 and thus forms an interpoly insulating layer. The gate oxide layer will typically have a thinner thickness than the interpoly insulating layer.

A stack 40 of layers is formed over each trench 18 and laterally extends on opposite sides of each trench 18 over at least a portion of the doped regions 26 for the source. Each stack 40 comprises a dielectric region formed by an undoped oxide (for example, tetraethyl orthosilicate (TEOS)) layer 44 and a glass (for example, borophosphosilicate glass (BPSG)) layer 46.

A source metal contact 50 is positioned between adjacent stacks 40 to make electrical contact with each doped source region 26. Each source metal contact 50 extends depthwise into the substrate from the front side 14 to pass through the doped source region 26 and into the doped body region 24 (thus providing a body contact for the transistor 10 that is tied to the source). A source metal layer 52 extends over both the stacks 40 and the source metal contacts 50 to provide a metal connection to all the source metal contacts 50. The stack 40 insulates the source metal layer 52 and the source metal contacts 50 from the gate (polysilicon region 32). An electrical connection (not explicitly shown but schematically illustrated by dotted line 55) is provided to electrically connect the source metal layer 52 to the field plate (polysilicon region 22a). A drain metal layer 54 extends over the back side 16 of the substrate 12 to provide a metal connection to the drain. A gate metal layer (not explicitly shown as it is offset in a direction perpendicular to the cross-section) makes an electrical connection to the gate (polysilicon region 32) in each trench 18, this gate metal layer and electrical connection being schematically shown by dotted line 56.

The transistor 10 could instead be a pMOS type transistor where the substrate 12 and doped source region 16 are both p-type doped and the body region 14 is n-type doped.

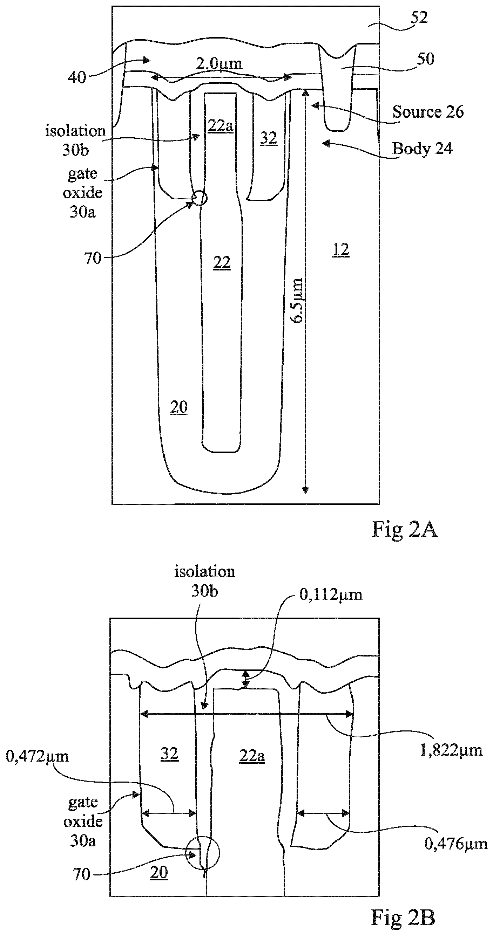

Scanning electron micrograph (SEM) cross-sectional images of a single cell of the transistor 10 are shown in Figures 2A and 2B. There is a desire to lower the threshold voltage of the power MOSFET 10. To achieve this, the thickness of the gate oxide formed by the second insulating layer 30a between the gate (polysilicon region 32) and the substrate 12 in the upper part of the trench 18 (specifically in the annular trench region) must be thin (for example, about 450-500A). With this reduction in gate oxide thickness, there is a corresponding reduction in the threshold voltage from about 3.5V to about 1.75V. The thermal oxidation process used to form the second insulating layer 30a affects not only the thickness of the gate oxide but also the interpoly isolation between the gate (polysilicon region 32) and the field plate electrode (polysilicon region 22) provided by the third insulating layer 30b. In particular, there is a concern that in providing a thinner second insulating layer 30a in order to reduce the threshold voltage there would be a corresponding thinning of the third insulating layer 30b in the region 70 (for example, with a thickness of 725-775Å), with this thinned insulation layer 30b resulting in a weak poly-to-poly isolation. The transistor 10 then experiences an unacceptable level of gate-to-source leakage current (IGSS) in response to the application of a gate voltage.

There is accordingly a need in the art for an improved process to manufacture a split-gate trench MOSFET structure that supports a lower threshold voltage while continuing to satisfy gate-to-source leakage current requirements.

### SUMMARY

In an embodiment, a method comprises: forming a substrate trench in a semiconductor substrate; lining the substrate trench with a first insulation layer; filling the substrate trench with a first conductive material insulated from the semiconductor substrate by said first insulating layer; forming a gate trench in the first insulation layer that removes a portion of the first insulation layer adjacent side walls in an upper part of the substrate trench and leaves an integral portion of the first insulation layer in place surrounding the first conductive material; lining sidewalls of the upper part of the substrate trench at said gate trench with a second insulating layer; and depositing a second conductive material in said gate trench, said second conductive material insulated from the semiconductor substrate by said second insulating layer and insulated from the first conductive material by said integral portion of the first insulation layer.

In an embodiment, an integrated circuit comprises: a semiconductor substrate having a front surface and a back surface; a substrate trench extending into the semiconductor substrate from the front surface, said substrate trench including a lower part and an upper part, said upper part being adjacent the front surface of the semiconductor substrate; a first insulation layer within said substrate trench; a first conductive material in the substrate trench and insulated from the semiconductor substrate by said first insulating layer; a gate trench extending in said first insulation layer adjacent side walls in the upper part of the substrate trench which leaves an integral portion of the first insulation layer at the upper part of the substrate trench surrounding the first conductive material; and a second conductive material in said gate trench, said second conductive material insulated from the semiconductor substrate by said second insulating layer and insulated from the first conductive material by said integral portion of the first insulation layer.

### BRIEF DESCRIPTION OF THE DRAWINGS

For a better understanding of the embodiments, reference will now be made by way of example only to the accompanying figures in which:
Figure 1 is a cross-section of a power metal oxide semiconductor field effect transistor (MOSFET) device;
Figures 2A and 2B are scanning electron micrograph images of a cross-section of the power MOSFET device of Figure 1;
Figure 3 is a cross-section of a power MOSFET device; and
Figures 4A-4L show process steps in the fabrication of the MOSFET device of Figure 3.

### DETAILED DESCRIPTION

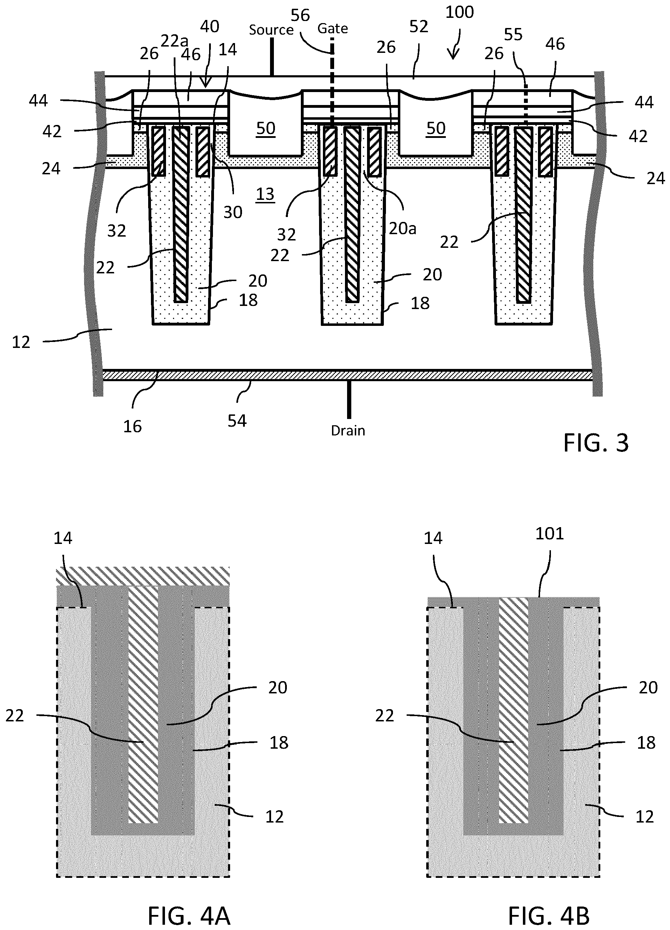

Reference is made to Figure 3 which shows an embodiment of a cross-section of a split-gate trench power metal oxide semiconductor field effect transistor (MOSFET) device 100. In this example, the MOSFET device 100 is an n-channel (nMOS) type device formed in and on a semiconductor substrate 12 (for example, silicon) doped with n-type dopant providing the drain region of the transistor 100. The substrate 12 has a front side 14 and a back side 16. A plurality of trenches 18 extend depthwise into the substrate 12 from the front side 14. The trenches 18 extend lengthwise parallel to each other in a direction perpendicular to the cross-section (i.e., into and out the page of the illustration), with adjacent trenches delimiting side edges of a mesa region 13 of the transistor forming a strip (this type of transistor device commonly referred to in the art as a strip-FET type transistor).

A region 24 doped with a p-type dopant is buried in the mesa region 13 of the substrate 12 at a depth offset from (i.e., below) the front side 14 and positioned extending parallel to the front side 14 on opposite sides of each trench 18. The doped region 24 forms the body (channel) region of the transistor, with the trench 18 passing completely through the doped body region 24 and into the substrate 12 below the doped body region 24. A surface region 26 heavily doped with an n-type dopant is provided in the mesa region 13 at the front side 14 of the substrate 12 and positioned extending parallel to the front side 14 on opposite sides of each trench 18 and in contact with the top of the doped body region 24. The doped region 26 forms the source region of the transistor, with the trench 18 passing completely through the doped source region 26 and further extending, as noted above, completely through the doped body region 24 into the substrate 12 below the doped body region 24.

The side walls and bottom of each trench 18 are lined with a first insulating layer 20. Each trench 18 is filled by a first polysilicon material 22, with the first insulating layer 20 insulating the first polysilicon material 22 from the substrate 12. The first polysilicon material 22 in the trench 18 forms a field plate electrode of the transistor 100. An upper portion of the first insulating layer 20 located along the side wall of the trench 18 adjacent to both the doped body region 24 and doped region 26 is selectively removed from an upper part of the trench 18 to form a gate trench. The gate trench is spaced from an upper portion 22a of the first polysilicon material 22 by a corresponding portion 20a of the first insulating layer 20 (left in place) that annularly surrounds the upper portion 22a of the first polysilicon material 22. In this regard, it will be noted that the portion 20a is an integral part of the first insulating layer 20. The exposed side walls at the upper part of the trench 18 in the gate trench are then lined with a second insulating layer 30. For example, the second insulating layer 30 may comprise an oxide layer (which, in an embodiment, is thermally grown from the exposed surfaces of the substrate 12 at the upper part of the trench 18). The remaining open portion of the gate trench is then filled by a second polysilicon material 32. The second polysilicon material 32 in the gate trench forms the gate of the transistor 100. The second insulating layer 30 insulates the second polysilicon material 32 from the substrate 12 and forms the gate oxide layer for the transistor. The integral portion 20a of the first insulating layer 20 that was left in place insulates the polysilicon material (gate) 32 from the upper portion 22a of the first polysilicon material (field plate) 22 and thus forms an interpoly insulating layer. The gate oxide layer formed by second insulating layer 30 will typically have a thickness in a range of 400-800Å, while the interpoly insulating layer formed by the portion 20a of the first insulating layer 20 will typically have a thickness greater than 700Å (for example, in a range of 700-1600Å) or greater than 1000Å (for example in a range of 1000-5000Å).

A stack 40 of layers is formed over each trench 18 and laterally extends on opposite sides of each trench 18 over at least a portion of the doped regions 26 for the source. Each stack 40 comprises a silicon nitride layer 42, a dielectric region formed by an undoped oxide (for example, tetraethyl orthosilicate (TEOS)) layer 44 and a glass (for example, borophosphosilicate glass (BPSG)) layer 46.

A source metal contact 50 is located between adjacent stacks 40 to make electrical contact with each doped source region 26. Each source metal contact 50 extends depthwise into the substrate from the front side 14 to pass through the doped source region 26 and into the doped body region 24 (thus providing a body contact for the transistor 100 that is tied to the source). A source metal layer 52 extends over both the stacks 40 and the source metal contacts 50 to provide a metal connection to all the source metal contacts 50. The stack 40 insulates the source metal layer 52 and the source metal contacts 50 from the gate (polysilicon region 32). An electrical connection (not explicitly shown but schematically illustrated by dotted line 55) is provided to electrically connect the source metal layer 52 to the field plate (polysilicon region 22a). A drain metal layer 54 extends over the back side 16 of the substrate 12 to provide a metal connection to the drain. A gate metal layer (not explicitly shown as it is offset in a direction perpendicular to the cross-section) makes an electrical connection to the gate (polysilicon region 32) in each trench 18, this gate metal layer and electrical connection being schematically shown by dotted line 56.

The transistor 100 could instead be a pMOS type transistor where the substrate 12 and doped source region 16 are both p-type doped and the body region 14 is n-type doped.

Reference is now made to Figures 4A-4L which show process steps in the fabrication of the MOSFET transistor 100 of Figure 3.

A trench 18 is formed in a substrate 12. The sidewalls and bottom of the lower part and upper part of the trench 18 are lined with an insulating layer 20 that further extends on the front side 14 of the substrate 12. The lower and upper parts of the trench 18 are then filled with first polysilicon (conductive) material 22 that further extends on the insulating layer 20 at the front side 14 of the substrate 12. The insulating layer 20 insulates the first polysilicon material 22 from the substrate 12. The result is shown in Figure 4A.

A polishing operation (for example, a chemical-mechanical polishing (CMP)) is performed to remove the first polysilicon material 22 which is not located within the trench 18 and thin the insulating layer 20 extending on the front side 14 of the substrate 12 to provide a flat upper surface 101. The result is shown in Figure 4B.

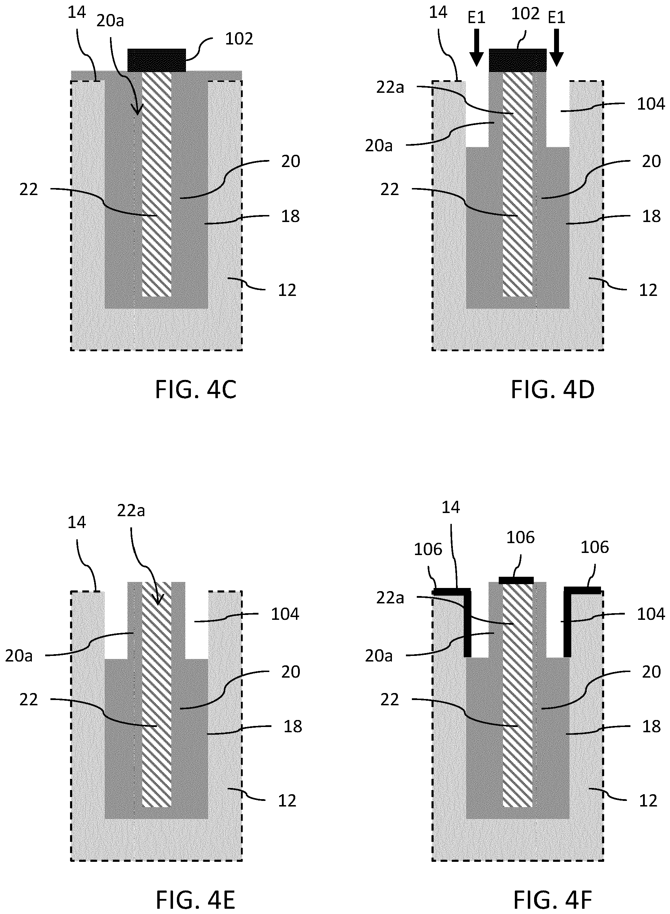

A lithographically patterned mask 102 (for example, comprising a resist made of a resin material) is then formed on the surface 101 over the first polysilicon material 22 and the portion 20a of the first insulating layer 20. The result is shown in Figure 4C.

An oxide selective dry etch E1 is then performed at an upper part of the trench 18 not covered by the mask 102 to remove an upper portion of the first insulating layer 20 located along the side wall of the trench 18 adjacent to where both the doped body region 24 and doped region 26 (see, Figure 3) will be located and form a gate trench 104 that is spaced from an upper portion 22a of the first polysilicon material 22 by a corresponding integral portion 20a of the first insulating layer 20 that is left in place and annularly surrounds the upper portion 22a of the first polysilicon material 22. The result is shown in Figure 4D. It will be noted that the width of (i.e., size of, dimension of) the mask 102 sets a lateral thickness of the integral portion 20a (preferably greater than 700Å, for example in a range of 700-1600Å, or greater than 1000Å, for example in a range of 1000-5000Å) which remains in the trench 18 to isolate the upper portion 22a of the first polysilicon material 22. Furthermore, a duration of the dry etch E1 sets a depth of the gate trench 104 which defines a gate length of the transistor 100.

The mask 102 is then removed using a resist strip process. The result is shown in Figure 4E.

A thermal oxidation is then performed to form a sacrificial insulating layer 106 on the sidewalls of the upper part of the trench 18 (within the gate trench 104) and on an upper surface of the upper portion 22a of the first polysilicon material 22. The result is shown in Figure 4F. The sacrificial insulating layer 106 may, for example, have a thickness in a range of 500-1000Å.

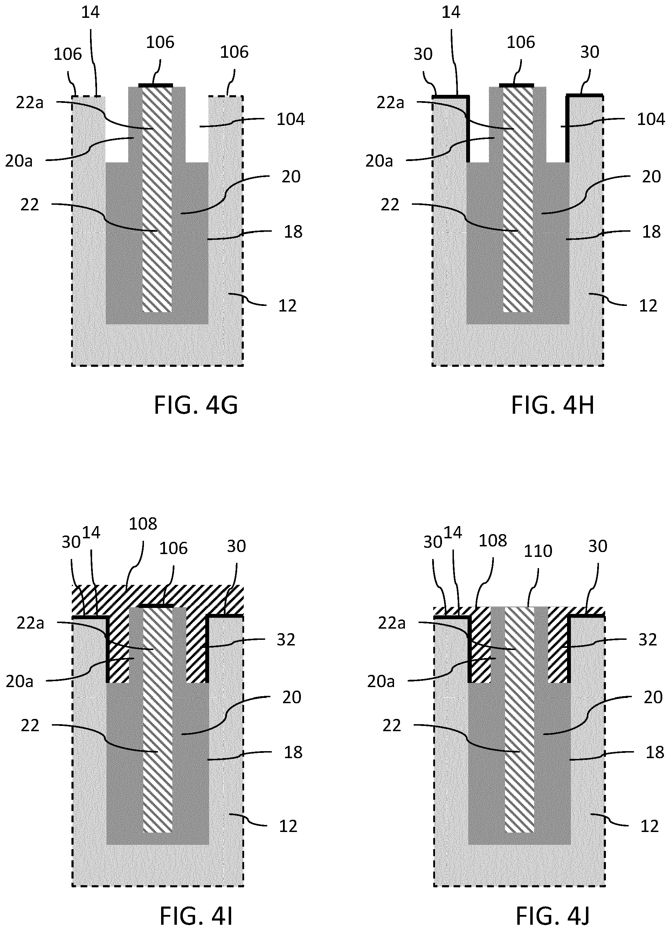

A wet etch is then performed to substantially remove the portions of the sacrificial insulating layer 106 located on surfaces of the substrate 12 (for example, within the gate trench 104 and on the upper surface 14 of the substrate 12) while thinning, but not removing, the portion of the sacrificial insulating layer 106 located on the upper surface of the upper portion 22a of the first polysilicon material 22. The result is shown in Figure 4G. The portion of the sacrificial insulating layer 106 located on the upper surface of the upper portion 22a forms a cap structure for protecting the first polysilicon material 22.

A thermal oxidation is then performed to form the second insulating layer 30 on the sidewalls of the upper part of the trench 18 in the area of the gate trench 104. The result is shown in Figure 4H. The second insulating layer 30 may, for example, have a thickness in a range of 400-800Å, and the provides the gate oxide layer for the transistor 100.

A polysilicon layer 108 is then deposited to fill the gate trench 104. This polysilicon deposition is conformal in nature and thus also covers the upper surface of the substrate 12, the portion 20a of the first insulating layer 20, and the upper portion 22a of the first polysilicon material 22. The result is shown in Figure 4I. The portion of the polysilicon layer 108 located within the gate trench 104 will eventually form the transistor gate.

A polishing operation (for example, a chemical-mechanical polishing (CMP)) is performed to thin the polysilicon layer 108 and provide a flat upper surface 110 substantially level with the upper surfaces of the portion 20a of the first insulating layer 20 and the upper portion 22a of the first polysilicon material 22. The result is shown in Figure 4J. This CMP step planarizes the surface and removes any poly deposition/etchback thickness variation that is recognized to cause poly residue or poly overetch problems that impact the yield. Also, due to limitation of availability of poly slurry (with selectivity to oxide), this CMP step cannot stop at an oxide (on mesa), but instead uses an alternative oxide and poly etch which can result in a not exactly (i.e., not perfectly) planarized upper surface. Such a surface characteristic is indicative of the performance of the polishing operation at this stage of the transistor device manufacture.

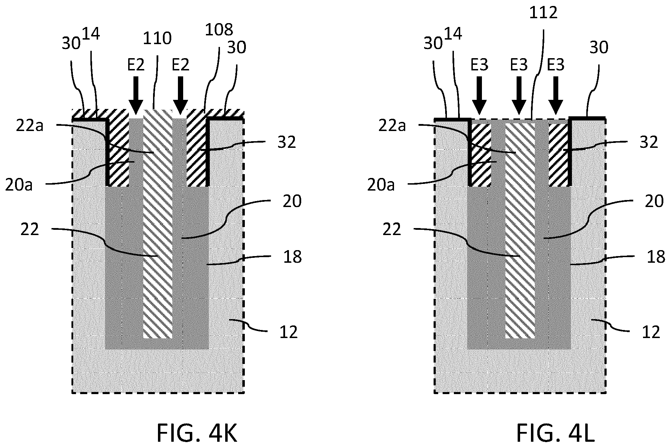

An oxide selective wet etch E2 is then performed at an upper part of the trench 18 to recess the portion 20a of the first insulating layer 20 from surface 110. The result is shown in Figure 4K. A duration of the wet etch E2 sets a depth of the recess to be, for example, in a range of 1800-2200Å (for example, about 2000Å) below surface 110.

A polysilicon selective etch back E3 is then performed to recess both the upper portion 22a of the first polysilicon material 22 and the upper portion of the polysilicon layer 108 within the gate trench 104 that provides the second polysilicon material 32 in the gate trench forming the gate of the transistor 100. The depth of the etch back E3 is controlled so that an upper surface of the both the upper portion 22a of the first polysilicon material 22 and the upper portion of the polysilicon layer 108 within the gate trench 104 are below the recessed portion 20a of the first insulating layer 20. The polysilicon etch back is important to ensure removal of unwanted polysilicon residue that could lead to device failure or improper operation. Following the etch back E3, a thermal oxidation is performed to form an insulating layer 112 on the upper surfaces of the upper portion 22a of the first polysilicon material 22 and the second polysilicon material 32. The result is shown in Figure 4L. This insulating layer 112 serves to ensure an insulating seal of first polysilicon material (field plate) 22 and second polysilicon material (gate) 32.

The process then continues with standard fabrication techniques for completing construction of the transistor 100 (this includes steps for implanting the source region 26 and body region 24). The stack 40 is then deposited over the insulating layer 112 and on the upper surface of the substrate (silicon nitride layer 42 approximately 650-750Å thick; TEOS layer 44 approximately 1900-2100Å thick and BPSG layer 46 approximately 6250-6750Å thick). Openings for the source-body contacts are then formed to extend through the stack 40 and into the substrate 12. The openings are then filled with the material for the source contact 50. The source layer 52 is then deposited over the stack 40 and source contact 50. At any suitable time in the process, the drain contact 54 may be deposited on the back side 16 of the substrate 12. The result of these standard fabrication techniques is shown in Figure 3.

The position and thickness of the integral portion 20a of the first insulating layer 20 that annularly surrounds the upper portion 22a of the first polysilicon material 22 can also be controlled through the mask 102 definition and etch E1 process to provide sufficient insulation between the gate (polysilicon region 32) and the field plate electrode (polysilicon region 22) to produce a strong poly-to-poly isolation necessary for achieving a desired level of gate-to-source leakage current (IGSS). This is accomplished without compromising the thickness of the gate oxide second insulating layer 30 on the sidewalls of the upper part of the trench 18 in the area of the gate trench 104 in order to support a lower transistor threshold voltage.

The transistor embodiment described herein provides for a good interpoly isolation by using a manufacturing process that decouples the formation of the interpoly oxide from the gate oxidation process. This manufacturing process allows for the formation of a thick interpoly oxide which improves transistor performance parameters such as: gate leakage (IGSS), reliability high temperature gate bias (HTGB) and also the input capacitance (Ciss). With this manufacturing process, further gate oxide thickness scaling, especially to cater to logic-level threshold voltage (Vth) application can be achieved without the worrying about the interpoly oxide leakage problem.

It will be noted that the process described herein and illustrated in Figures 4A-4L may also be used in connection with the formation of other trench field plate power MOSFET devices where a thick interpoly isolation between gate and field plate is needed in connection with the provision of a thin gate oxide layer.

The present encompasses the following examples.

Example 1: A method, comprising:
forming a substrate trench in a semiconductor substrate;
lining the substrate trench with a first insulation layer;
filling the substrate trench with a first conductive material insulated from the semiconductor substrate by said first insulating layer;
forming a gate trench in the first insulation layer that removes a portion of the first insulation layer adjacent side walls in an upper part of the substrate trench and leaves an integral portion of the first insulation layer in place surrounding the first conductive material;
lining sidewalls of the upper part of the substrate trench at said gate trench with a second insulating layer; and
depositing a second conductive material in said gate trench, said second conductive material insulated from the semiconductor substrate by said second insulating layer and insulated from the first conductive material by said integral portion of the first insulation layer.

Example 2: The method of example 1, further comprising, after forming the gate trench and before lining the sidewalls:
forming a sacrificial insulating layer on sidewalls of the upper part of the substrate trench and on an upper surface of the first conductive material; and
removing a first portion of the sacrificial insulating layer on sidewalls of the upper part of the substrate trench while leaving a second portion of the sacrificial insulating layer on the upper surface of the first conductive material.

Example 3: The method of example 1 or 2, further comprising, after depositing the second conductive material in said gate trench:
polishing to thin the second conductive material and provide an upper conductive material surface;
selectively recessing an upper part of the integral portion of the first insulation layer below said upper conductive material surface;
selectively recessing an upper part of the second conductive material in said gate trench below the recessed integral portion of the first insulation layer;
selectively recessing an upper part of the first conductive material below the recessed integral portion of the first insulation layer; and
forming a third insulating layer on upper surfaces of the recessed upper part of the second conductive material and upper part of the first conductive material.

Example 4: The method of example 3, wherein the third insulating layer is a thermal oxide.

Example 5: The method of example 3 or 4, further comprising, after forming the third insulating layer, forming a nitride layer on the third insulating layer.

Example 6: The method of any of examples 1 to 5, wherein the first and second conductive materials are made of polysilicon.

Example 7: The method of any of examples 1 to 6, wherein the first insulating layer is an oxide and the second insulating layer is a thermal oxide.

Example 8: The method of any of examples 1 to 7, wherein the semiconductor substrate provides a drain region of a transistor, further comprising:
forming a doped buried region in the semiconductor substrate which provides a body region of the transistor; and
forming a doped surface region in the semiconductor substrate over the doped buried region which provides a source region of the transistor.

Example 9: The method of example 8, wherein the first conductive material provides a field plate electrode of the transistor and the second conductive material provides a gate electrode of the transistor.

Example 10: The method of example 8 or 9, further comprising:
forming an opening extending through the doped surface region and into the doped buried region; and
filling said opening with a third conductive material.

Example 11: The method of example 10, wherein the third conductive material provides a source contact for the transistor.

Example 12: The method of any of examples 1 to 11, wherein forming the gate trench comprises:
forming a mask covering the first conductive material and extending to cover the integral portion of the first insulation layer surrounding the first conductive material; and
performing an oxide selective etch to remove said portion of the first insulation layer not covered by the mask.

Example 13: The method of example 12, further comprising defining dimensions of said mask to provide the covered integral portion of the first insulation layer surrounding the first conductive material with a lateral thickness in a range of 1000-1250Å, and wherein said second insulating layer has a thickness in a range of 400-800Å.

Example 14: An integrated circuit, comprising:
a semiconductor substrate having a front surface and a back surface;
a substrate trench extending into the semiconductor substrate from the front surface, said substrate trench including a lower part and an upper part, said upper part being adjacent the front surface of the semiconductor substrate;
a first insulation layer within said substrate trench;
a first conductive material in the substrate trench and insulated from the semiconductor substrate by said first insulating layer;
a gate trench extending in said first insulation layer adjacent side walls in the upper part of the substrate trench which leaves an integral portion of the first insulation layer at the upper part of the substrate trench surrounding the first conductive material;
a second insulating layer lining sidewalls of the upper part of the substrate trench at said gate trench; and
a second conductive material in said gate trench, said second conductive material insulated from the semiconductor substrate by said second insulating layer and insulated from the first conductive material by said integral portion of the first insulation layer.

Example 15: The integrated circuit of example 14, wherein the first and second conductive materials are each made of polysilicon.

Example 16: The integrated circuit of example 14 or 15, wherein the first insulating layer is an oxide and the second insulating layer is a thermal oxide.

Example 17: The integrated circuit of any of examples 14 to 16, wherein the semiconductor substrate provides a drain region of a transistor, further comprising:
a doped buried region in the semiconductor substrate which provides a body region of the transistor; and
a doped surface region in the semiconductor substrate over the doped buried region which provides a source region of the transistor.

Example 18: The integrated circuit of example 17, wherein the first conductive material provides a field plate electrode of the transistor and the second conductive material provides a gate electrode of the transistor.

Example 19: The integrated circuit of example 17 or 18, further comprising:
opening extending through the doped surface region and into the doped buried region; and
a third conductive material filling said opening.

Example 20. The integrated circuit of example 19, wherein the third conductive material provides a source contact for the transistor.

Example 21. The integrated circuit of any of examples 15 to 20, wherein a lateral thickness of the integral portion of the first insulation layer surrounding the first conductive material is in a range of 1000-1250Å, and wherein said second insulating layer has a thickness in a range of 400-800Å.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A method, comprising:
forming a substrate trench in a semiconductor substrate;
lining the substrate trench with a first insulation layer;
filling the substrate trench with a first conductive material insulated from the semiconductor substrate by said first insulating layer;
forming a gate trench in the first insulation layer that removes a portion of the first insulation layer adjacent side walls in an upper part of the substrate trench and leaves an integral portion of the first insulation layer in place surrounding the first conductive material;
lining sidewalls of the upper part of the substrate trench at said gate trench with a second insulating layer; and
depositing a second conductive material in said gate trench, said second conductive material insulated from the semiconductor substrate by said second insulating layer and insulated from the first conductive material by said integral portion of the first insulation layer.

2. The method of claim 1, further comprising, after forming the gate trench and before lining the sidewalls:
forming a sacrificial insulating layer on sidewalls of the upper part of the substrate trench and on an upper surface of the first conductive material; and
removing a first portion of the sacrificial insulating layer on sidewalls of the upper part of the substrate trench while leaving a second portion of the sacrificial insulating layer on the upper surface of the first conductive material.

3. The method of claim 1 or 2, further comprising, after depositing the second conductive material in said gate trench:
polishing to thin the second conductive material and provide an upper conductive material surface;
selectively recessing an upper part of the integral portion of the first insulation layer below said upper conductive material surface;
selectively recessing an upper part of the second conductive material in said gate trench below the recessed integral portion of the first insulation layer;
selectively recessing an upper part of the first conductive material below the recessed integral portion of the first insulation layer; and
forming a third insulating layer on upper surfaces of the recessed upper part of the second conductive material and upper part of the first conductive material.

4. The method of claim 3, wherein the third insulating layer is a thermal oxide.

5. The method of claim 3 or 4, further comprising, after forming the third insulating layer, forming a nitride layer on the third insulating layer.

6. An integrated circuit, comprising:
a semiconductor substrate having a front surface and a back surface;
a substrate trench extending into the semiconductor substrate from the front surface, said substrate trench including a lower part and an upper part, said upper part being adjacent the front surface of the semiconductor substrate;
a first insulation layer within said substrate trench;
a first conductive material in the substrate trench and insulated from the semiconductor substrate by said first insulating layer;
a gate trench extending in said first insulation layer adjacent side walls in the upper part of the substrate trench which leaves an integral portion of the first insulation layer at the upper part of the substrate trench surrounding the first conductive material;
a second insulating layer lining sidewalls of the upper part of the substrate trench at said gate trench; and
a second conductive material in said gate trench, said second conductive material insulated from the semiconductor substrate by said second insulating layer and insulated from the first conductive material by said integral portion of the first insulation layer.

7. The integrated circuit of claim 6, further comprising a third insulating layer on upper surfaces of upper part of the second conductive material and upper part of the first conductive material.

8. The method of any of claims 1 to 5, or the integrated circuit of claims 6 or 7, wherein the first and second conductive materials are made of polysilicon.

9. The method of any claims 1 to 5, 8, or the integrated circuit of any of claims 6 to 8, wherein the first insulating layer is an oxide and the second insulating layer is a thermal oxide.

10. The method of any of claims 1 to 5, 8, 9, or the integrated circuit of any of claims 6 to 9, wherein the semiconductor substrate provides a drain region of a transistor, said method further comprising forming, or said integrated circuit further comprising:
a doped buried region in the semiconductor substrate which provides a body region of the transistor; and
a doped surface region in the semiconductor substrate over the doped buried region which provides a source region of the transistor.

11. The method or the integrated circuit of claim 10, wherein the first conductive material provides a field plate electrode of the transistor and the second conductive material provides a gate electrode of the transistor.

12. The method of claim 10 or 11, further comprising:
forming an opening extending through the doped surface region and into the doped buried region; and
filling said opening with a third conductive material,
or the integrated circuit of claim 10 or 11, further comprising:
opening extending through the doped surface region and into the doped buried region; and
a third conductive material filling said opening.

13. The method or the integrated circuit of claim 12, wherein the third conductive material provides a source contact for the transistor.

14. The method of any of claims 1 to 5, 8 to 13, wherein forming the gate trench comprises:
forming a mask covering the first conductive material and extending to cover the integral portion of the first insulation layer surrounding the first conductive material; and
performing an oxide selective etch to remove said portion of the first insulation layer not covered by the mask.

15. The method of claim 14 further comprising defining dimensions of said mask to provide the covered integral portion of the first insulation layer surrounding the first conductive material with a lateral thickness in a range of 1000-1250Å, or the integrated circuit of claim 14 wherein a lateral thickness of the integral portion of the first insulation layer surrounding the first conductive material is in a range of 1000-1250Å, and wherein said second insulating layer has a thickness in a range of 400-800Å.
